# EUROPÄISCHE PATENTSCHRIFT

(11) **EP 1 537 610 B1**
(45) Veröffentlichungstag und Bekanntmachung des Hinweises auf die Patenterteilung: **19.04.2006**
(21) Anmeldenummer: 03797169.4
(22) Anmeldetag: 13.08.2003
(51) Int. Cl.: H01L 41/083, H01L 41/047

(54) **PIEZOELEKTRISCHER AKTOR**
PIEZOELECTRIC ACTUATOR
ACTIONNEUR PIEZO-ELECTRIQUE

(30) Priorität: 11.09.2002 DE 10241992
(43) Veröffentlichungstag der Anmeldung: 08.06.2005
(73) Patentinhaber: SIEMENS AKTIENGESELLSCHAFT, 80333 München (DE)
(72) Erfinder: SCHÜRZ, Willibald, 93188 Pielenhofen (DE); SIMMET, Martin, 93077 Bad Abbach (DE)
(86) Internationale Anmeldenummer: PCT/DE2003/002730
(87) Internationale Veröffentlichungsnummer: WO 2004/027887

(56) Entgegenhaltungen:
- EP-A- 1 065 735
- DE-A- 10 017 975
- DE-A- 10 113 744
- DE-A- 19 913 271
- DE-A- 19 917 728
- DE-A- 19 928 189
- DE-A- 19 928 780
- PATENT ABSTRACTS OF JAPAN Bd. 1997, Nr. 01, 31. Januar 1997 (1997-01-31) -& JP 08 242025 A (HITACHI METALS LTD), 17. September 1996 (1996-09-17)
- PATENT ABSTRACTS OF JAPAN Bd. 2002, Nr. 11, 6. November 2002 (2002-11-06) -& JP 2002 202024 A (DENSO CORP), 19. Juli 2002 (2002-07-19)
- PATENT ABSTRACTS OF JAPAN Bd. 1998, Nr. 02, 30. Januar 1998 (1998-01-30) -& JP 09 270539 A (CHICHIBU ONODA CEMENT CORP), 14. Oktober 1997 (1997-10-14)

## Beschreibung

Die Erfindung betrifft einen piezoelektrischen Aktor nach dem Oberbegriff des Anspruchs 1.

Gattungsbildende piezoelektrische Aktoren werden häufig zur Ansteuerung von Einspritzventilen bei Kraftfahrzeugen verwendet.

Piezokeramiken haben die Eigenschaft sich beim Anlegen einer elektrischen Spannung, je nach Polarität der Spannung, auszudehnen beziehungsweise zusammenzuziehen. Dieser Effekt wird bei piezoelektrischen Aktoren ausgenutzt. Die nutzbare Längenausdehnung beträgt allerdings weniger als 2 Promille der Schichtdicke der Piezokeramik entlang der Hauptachse. Gleichzeitig steigt mit zunehmender Schichtdicke des Piezoelements die zum Ansprechen des Piezoelements erforderliche elektrische Spannung. Um die Spannung in Grenzen zu halten und gleichzeitig eine technisch sinnvolle Längeausdehnung zu erreichen werden üblicherweise mehrere Piezokeramikschichten übereinander angeordnet. Die einzelnen piezokeramischen Schichten, die nachfolgend als piezoelektrische Aktorelemente bezeichnet werden, sind zur Polarisierung beidseitig mit metallischen Innenelektroden versehen.

Aus der DE 196 48 545 A1 ist bereits ein piezoelektrischer Aktor bekannt, der zur elektrischen Kontaktierung der piezoelektrischen Aktorelemente an seiner Außenseite zwei Metallisierungsstreifen aufweist. Die Innenelektroden sind jeweils alternierend mit einer der beiden Metallisierungsstreifen verbunden und über Außenelektroden elektrisch parallel geschaltet. Hierzu sind die Außenelektroden mit Anschlusselementen zur Außenkontaktierung des piezoelektrischer Aktor versehen.

Aufgrund der hohen dynamischen Belastung des piezoelektrischen Aktors kann es zu Rissen in der Keramik kommen. Hierdurch kann der Metallisierungsstreifen durchtrennt werden. An der Risskante führt dies zu Spannungsüberschlägen die zu einer Zerstörung des piezoelektrischen Aktors führen.

Die DE 196 48 545 A1 schlägt zur Vermeidung von Ausfällen des piezoelektrischen Aktors bei dynamischen Belastungen vor, zwischen den Metallisierungsstreifen und der Außenkontaktierung dreidimensional strukturierte, elektrisch leitende Elektroden vorzusehen, die über partielle Kontaktstellen mit den Metallisierungsstreifen verbunden sind und zwischen den Kontaktstellen dehnbar ausgebildet sind.

Die EP 1 065 735 A2 und die DE 101 13 744 A1 offenbaren piezoelektrische Aktoren nach den Oberbegriff des Auspruchs 1.

Aufgrund der zunehmend engeren Platzverhältnisse im Motorraum ist allerdings immer weniger Bauraum für die einzelnen Motorkomponenten vorhanden.

Der Erfindung liegt daher die Aufgabe zugrunde, einen piezoelektrischen Aktor nach dem Oberbegriffs des Anspruchs 1 derart zu verbessern, dass bei minimalen Bauraumbedarf, auch bei hohen dynamischen Belastungen, eine sichere elektrische Kontaktierung gewährleistet wird.

Die Aufgabe wird gelöst durch die Merkmale des unabhängigen Patentanspruchs. Vorteilhafte Ausgestaltung der Erfindung sind in den Unteransprüchen gekennzeichnet.

Die Erfindung zeichnet sich dadurch aus, dass die Außenelektroden mindestens einen Bereich umfassen, der so ausgebildet ist, das er Längenänderungen des piezoelektrischen Aktors in Hauptschwingungsrichtung aufgrund seiner Formgebung und Anordnung durch elastische Verformung ausgleicht. Wobei die elastische Verformung ausschließlich innerhalb jeweils einer Ebene verläuft, die parallel zur Hauptschwingungsrichtung liegt. Nachfolgend wird diese Ebene als Schwingungsebene bezeichnet.

Die Außenelektrode, die derart geformt ist, dass sie eine hohe elastische Verformung ermöglichen, gewährleistet dabei die zuverlässige und dauerhafte Kontaktierung des piezoelektrischen Aktors. Aufgrund der elastischen Verformung in jeweils einem Bereich ausschließlich innerhalb jeweils einer Ebene, die parallel zur Hauptschwingungsrichtung des piezoelektrischen Aktors verläuft, wird ein minimalen Bauraumbedarf erreicht.

Die Bereiche der Außenelektrode sind dabei vorzugsweise parallel, mit geringst möglichem Abstand, zu den jeweiligen Seitenwänden des piezoelektrischen Aktors angeordnet. Hierdurch ergibt sich eine besonders kompakte Bauform. Denkbar sind aber auch anders, parallel zur Hauptschwingungsrichtung, angeordnete Bereiche, beispielsweise bei halbkreisförmigen Außenelektroden, die den piezoelektrischen Aktor umschließen. Die Schwingungsebenen ergeben sich hierbei durch alle Ebenen, die den Halbkreis tangential berühren.

Die Außenelektroden weisen ein kammartiges Profil mit Kontaktzinken auf. Die Kontaktzinken können zur Kontaktierung der Innenelektronen auf einfache Weise mit dem Metallisierungsstreifen, beispielsweise durch verlötet, elektrisch leitend verbunden werden. Zwischen den einzelnen Lötpunkten ermöglicht das kammartige Profil eine große elastische Verformung. Selbstverständlich sind auch andere Profilformen denkbar, die eine hohe elastische Verformung in Hauptschwingungsrichtung ermöglichen, beispielsweise ein Sinus- oder Dreieckprofil, diese sind jedoch nicht Bestandteil der vorliegenden Erfindung.

Die Außenelektroden weisen eine mäanderförmige Leiterplatine auf, von der aus die Kontaktzinken wegführen.

Ausführungsbeispiele der Erfindung werden im folgenden anhand der schematischen Zeichnungen erläutert. Es zeigt:
Figur 1 einen piezoelektrischen Aktor mit elastisch verformbarer Außenelektrode,
Figur 2 eine Außenelektrode in ebener Darstellung,
Figur 3 eine gebogene Außenelektrode mit einseitig aufgetragener Klebstoffschicht,
Figur 4 eine gebogene Außenelektrode mit beidseitig aufgetragene Klebstoffschicht,
Figur 5 einen Schnitt durch einen piezoelektrischen Aktor mit aufgeklebter Außenelektrode.

Elemente gleicher Konstruktion und Funktion sind figurübergreifend mit den gleichen Bezugszeichen versehen.

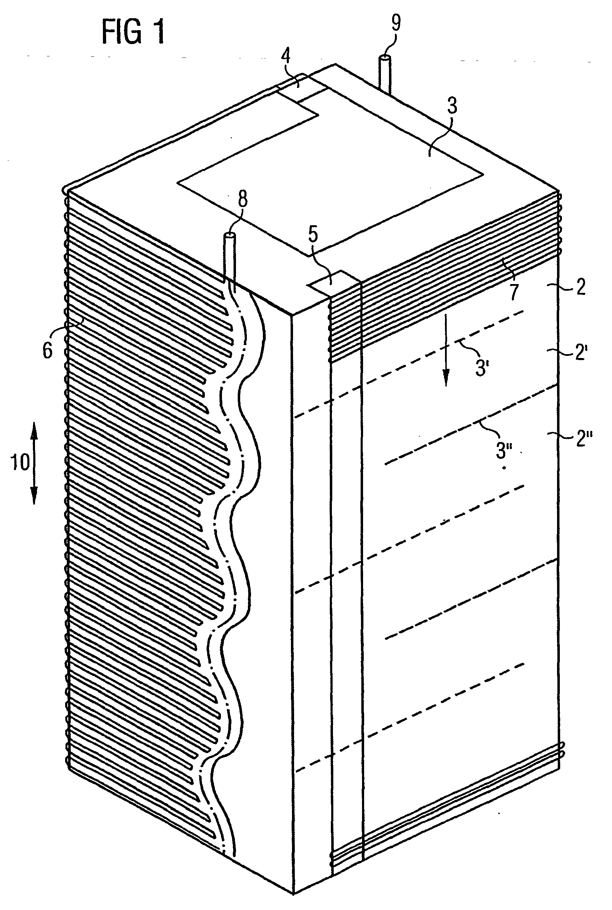

Figur 1 zeigt einen piezoelektrischen Aktor 1, mit einem Stapel mehrerer zwischen Innenelektroden 3, 3', 3" angeordneter, einzelner piezoelektrischer Aktorelemente 2, 2', 2''. Die Innenelektroden 3, 3', 3'' sind wechselseitig aus dem Stapel herausgeführt und elektrisch parallel geschaltet. Hierzu ist auf der Außenseite des piezoelektrischen Aktors 1 ein erster Metallisierungsstreifen 4 und ein zweiter Metallisierungsstreifen 5 aufgebracht. Die Innenelektroden 3, 3', 3'' sind jeweils alternierend mit dem ersten beziehungsweise dem zweiten Metallisierungsstreifen 4, 5 verbunden. Eine erste Außenelektrode 6 und eine zweite Außenelektrode 7 sind zur elektrischen Kontaktierung des piezoelektrischen Aktors an den ersten beziehungsweise zweiten Metallisierungsstreifen 4, 5 vorzugsweise durch Löten befestigt. Zur Außenkontaktierung des piezoelektrischen Aktors 1 sind die Außenelektroden 6, 7 mit einem ersten Anschlusselement 8 und einem zweiten Anschlusselement 9 verbunden. Legt man an die Außenelektroden 6, 7 eine elektrische Spannung an, so dehnen sich die piezoelektrischen Aktorelemente je nach Polarität der Spannung in Feldrichtung aus, beziehungsweise ziehen sich zusammen. Bei wechselnder Polarität führt der piezoelektrische Aktor somit eine Hauptschwingung in Feldrichtung aus.

Die Außenelektroden 6, 7 sind als kammartige Formteile ausgebildet und derart auf den piezoelektrischen Aktor 1 aufgebracht, dass sie in Hauptschwingungsrichtung 10, des piezoelektrischen Aktors 1, ihre größte Elastizität aufweisen. In der Figur sind die Formteile 6, 7 zur besseren mechanischen Fixierung derart gebogen, dass sie jeweils an zwei Seitenflächen des piezoelektrischen Aktors 1 befestigt sind.

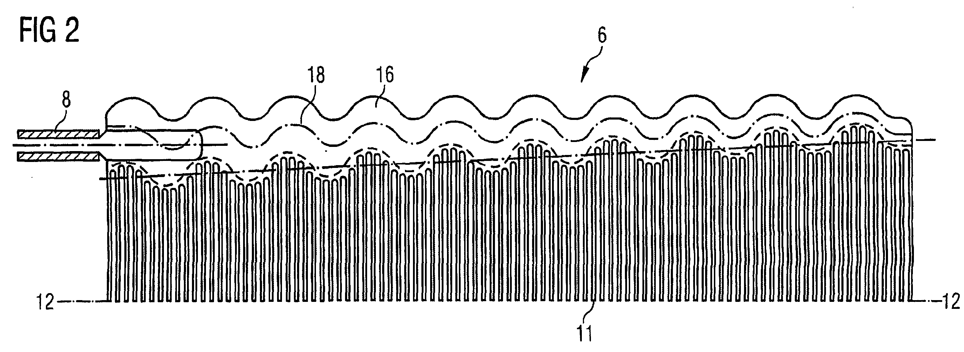

Figur 2 zeigt eine Außenelektrode 6 in Form eines Kammformteil in ebener Darstellung. Die elektrische Kontaktierung der Außenelektrode 6 erfolgt über ein Anschlusselement 8. Das Anschlusselement 8 ist dazu mit einem mäanderförmigen Bereich 16, der Außenelektrode 6 verbunden. Der mäanderförmige Bereich 16 ist als Leiterplatine ausgebildet, von dem einzelne, parallel zueinander verlaufende, Kontaktzinken 11 wegführen. Durch die mäanderförmige Ausgestaltung der Leiterplatte erreicht man in diesem Bereich eine hohe Elastizität. Die Kontaktzinken 11 bilden ein gerades Ende 12. Die Kontaktzinken 11 werden zur elektrischen Kontaktierung der Innenelektronen 3, 3",im Bereich des geraden Endes 12, an den Metallisierungsstreifen 4, vorzugsweise durch Löten, befestigt.

Der Strom wird über das Anschlusselement 8 in den mäanderförmigen Teil 16, der Außenelektrode 6 eingeleitet und fließt, über die einzelnen Kontaktzinken 11 und die Metallisierungszone 4, 5 zu den Innenelektronen 3, 3''. An der Kontaktstelle zwischen dem mäanderförmigen Teil 16, der Außenelektrode 6 und dem Anschlusselement 8 wird der gesamte Strom in die Außenelektrode 6 eingeleitet. Aus diesem Grund weist der mäanderförmigen Teil 16 an dieser Stelle einen größere Querschnitt auf. Da der Stromfluss im mäanderförmigen Teil 16, der Außenelektrode 6 entlang der Mittelachse 18 mit zunehmender Entfernung vom Anschlusselement 8 kontinuierlich abnimmt, verjüngt sich der Querschnitt des mäanderförmigen Teils 16 vorzugsweise entlang seiner Mittelachse 18. Durch die verjüngende Form des mäanderförmigen Teils 16 der Außenelektrode 6 erhöht man die Elastizität in diesem Bereich zusätzlich.

Die Außenelektrode 6 kann vorzugsweise aus einer Bronzelegierung (z.B. CuSn6) in Ätztechnik hergestellt werden.

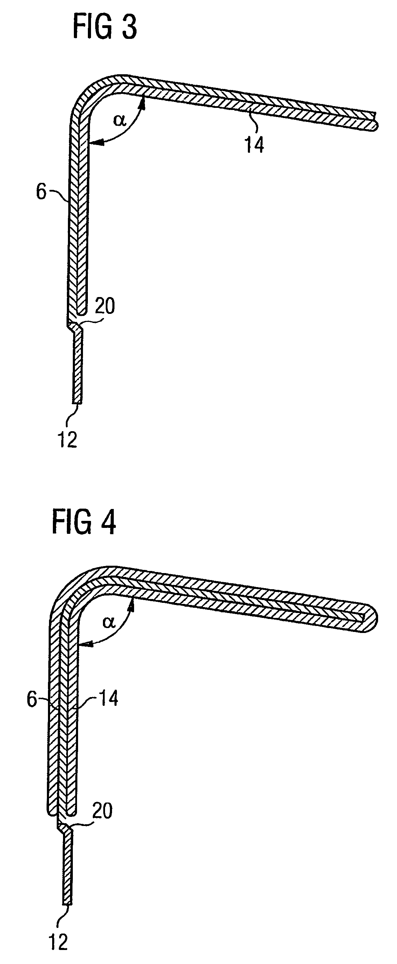

Figur 3 zeigt einen Schnitt durch die Außenelektrode 6. Die Außenelektrode 6 ist mittels Klebstoff 14 mechanisch am piezoelektrischen Aktor 1 befestigt. Vorzugsweise wird die Außenelektrode 6 zur Befestigung am piezoelektrischen Aktor 1, parallel zum ersten geraden Ende 12 der Kontaktzinken 11, um einen Winkel α gebogen. Vorzugsweise beträgt der Winkel α < 90°. Hierdurch entsteht beim Anpressen der Außenelektrode 6 auf den rechtwinkligen piezoelektrischen Aktor 1 eine Federkraft, welche während des Klebevorgangs ein Anliegen der Kontaktzinken 11, der Außenelektrode 6 an den piezoelektrischen Aktor 1 sicherstellt. Die Kontaktzinken 11 werden in einem Bereich um das gerade Ende 12, zur elektrischen Kontaktierung an die Metallisierungszone 4 angelötet. Dieser Bereich wird beim Auftragen des Klebstoffes 14 ausgespart. Um ein flächiges Anliegen im Bereich des geraden Endes 12, der Kontaktzinken 11, am Metallisierungsstreifen 4 zu gewährleisten, ist ein zusätzlicher Absatz 20 vorgesehen, der die Klebschicht 14 zwischen dem Formteil 6 und dem piezoelektrischen Aktor 1 ausgleicht.

Die Schichtdicke des Klebstoffs 14 wird durch den Zusatz von Partikeln mit vorgegebener Korngröße festgelegt. Der Klebstoff 14 ist derart ausgebildet das er eine elektrische Isolation zwischen der Außenelektrode 6 einerseits und den piezoelektrischen Aktorelementen 2, 2', 2" sowie den Innenelektroden 3, 3', 3" andererseits gewährleistet. Somit ist keine zusätzliche Isolationsschicht notwendig wodurch der Bauraumbedarf weiter verringert wird. Der Klebstoff ist dauerelastisch ausgebildet um auch während des Betriebs des piezoelektrischen Aktors 1, eine sichere Fixierung der Außenelektrode 6 zu gewährleisten.

Der Klebstoff 14 kann wie in Figur 3 dargestellt, einseitig auf der Innenseite des Formteils 6 oder beidseitig, wie in Figur 4 dargestellt, aufgetragen werden. Durch das beidseitige Auftragen des Klebstoffes 14 ergibt sich eine zusätzliche Isolation der Außenelektrode 6 gegenüber der äußeren Umgebung.

In Figur 2-4 ist jeweils nur der Aufbau der ersten Außenelektrode 6 beschrieben. Die zweite Außenelektrode 7 ist jedoch identisch aufgebaut so das auf eine zusätzliche Beschreibung verzichtet wurde.

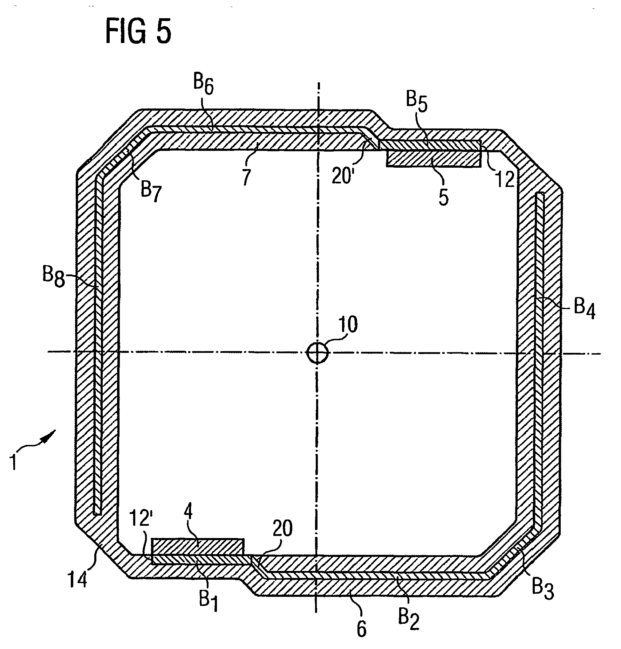

Figur 5 zeigt einen Schnitt durch den piezoelektrischen Aktor 1 mit den aufgeklebten Außenelektroden 6, 7. Der Schnitt liegt rechtwinklig zur Hauptschwingungsachse 10 des piezoelektrischen Aktors 1. Die jeweils geraden Abschnitte B₁-B₈ der ersten und zweiten Außenelektrode 6, 7 stellen jeweils einen Bereich der Außenelektroden da, der aufgrund seiner Formgebung und Anordnung, Längenänderungen des piezoelektrischen Aktors 1 durch elastische Verformung ausgleichen kann. Die elastische Verformung der jeweiligen Bereiche B₁-B₈ verläuft dabei jeweils innerhalb einer zur Bildebene Senkrechten Ebene, gekennzeichnet durch die jeweilige Strichpunktierte Linie, und parallel zur Hauptschwingungsrichtung 10.

Nach dem Aufkleben der Außenelektroden 6, 7 und dem Anlöten im Bereich des geraden Endes 12, 12' der Kontaktzinken 11, 11' ist der piezoelektrische Aktor 1 durchgehend mit einer Klebstoffschicht 22 versehen worden. Die durchgehende Klebstoffschicht 22 lässt sich beispielsweise durch einen Tauchprozess aufbringen. Hierdurch ist der piezoelektrische Aktor 1 elektrisch vollständig gegenüber der Umgebung abgeschirmt. Ein weiterer Vorteil dieser Ummantelung mittels Klebstoff besteht darin, dass bei Verwendung eines Kraftstoffresistenten Klebstoff der gesamte piezoelektrische Aktor 1 kraftstoffresistent hergestellt werden kann. Dies ist besonders vorteilhaft, da die Piezokeramik nur eine geringe Feuchtigkeitsbeständigkeit aufweist. Durch die geringe Feuchtigkeitsbeständigkeit kann Feuchtigkeit zu den Innenelektronen 3, 3', 3'' dringen, wodurch sich die dielektrischen Eigenschaften verschlechtert würden.

## Patentansprüche

1. piezoelektrischer Aktor (1) mit
- einem Stapel mehrerer, zwischen Innenelektroden (3, 3', 3'') angeordneter, einzelner piezoelektrischer Aktorelemente (2, 2', 2"), die sich in Abhängigkeit von einer angelegten elektrischen Spannung, in einer Hauptschwingungsrichtung (10) zusammenziehen oder ausdehnen,
- einem ersten Metallisierungsstreifen (4) und einem zweiten Metallisierungsstreifen (5), wobei die Innenelektroden (3, 3', 3'') jeweils alternierend mit dem ersten beziehungsweise zweiten Metallisierungsstreifen (4) (5) verbunden sind,
- einer ersten Außenelektrode (6) und einer zweiten Außenelektrode (7), die zur elektrischen Kontaktierung des piezoelektrischen Aktors (1), an dem ersten beziehungsweise an dem zweiten Metallisierungsstreifen (4) (5) befestigt sind und
- einem ersten Anschlusselement (8) sowie einem zweiten Anschlusselement (9) zur Außenkontaktierung des piezoelektrischen Aktors (1), die jeweils mit der ersten beziehungsweise mit der zweiten Außenelektrode (6) (7) verbunden sind,
wobei
- die Außenelektroden (6) (7) mindestens einen Bereich umfassen, der so ausgebildet ist, dass er Längenänderungen des piezoelektrischen Aktors (1) in Hauptschwingungsrichtung (10) aufgrund seiner Formgebung und Anordnung ausgleicht durch elastische verformung ausschließlich innerhalb jeweils einer Ebene, die parallel zur Hauptschwingungsrichtung (10) verläuft, und
- die Außenelektroden (6) (7) ein kammartiges Profil mit Kontaktzinken (11) (11') zur Kontaktierung der Metallisierungsstreifen (4) (5) aufweisen
**dadurch gekennzeichnet, dass**
die Außenelektroden (6) (7) eine mäanderförmige Leiterplatine (16) (16') aufweisen, von der aus die Kontaktzinken (11) (11') wegführen

2. Piezoelektrischer Aktor (1) nach Anspruch 1
**dadurch gekennzeichnet, dass**
die mäanderförmige Leiterplatte sich entlang ihrer Mittelachse (18) (18') verjüngt.

3. Piezoelektrischer Aktor (1) nach Anspruch 1 oder 2
**dadurch gekennzeichnet, dass**
die Kontaktzinken (11) (11') zueinander parallel verlaufen und an einem ersten Ende (12) (12') alle die gleiche Länge aufweisen und die Kontaktakzinken (11) (11') an diesem Ende (12) (12'), zur elektrischen Kontaktierung, an den Metallisierungsstreifen (4) (5) angelötet sind.

4. Piezoelektrischer Aktor (1) nach einem der Ansprüche 1 bis 3
**dadurch gekennzeichnet, dass**
die Außenelektroden (6) (7) zur Befestigung am piezoelektrischer Aktor (1), parallel zum ersten, geraden Endbereich (12) (12') der Kontaktzinken (11) (11'), um einen Winkel α < 90° gebogen sind.

5. Piezoelektrischer Aktor (1) nach einem der Ansprüche 1 bis 4
**dadurch gekennzeichnet, dass**
die Außenelektroden (6) (7) auf den piezoelektrischen Aktor (1), mittels eines Klebstoffs (14), mechanisch am piezoelektrischen Aktor (1) fixiert werden und die Kontaktzinken (11) (11') zum anlöten an die Metallisierungsstreifen (4) (5) beim Auftragen des Klebstoffes (14) ausgespart werden.

6. Piezoelektrischer Aktor (1) nach Anspruch 5
**dadurch gekennzeichnet, dass**
der Klebstoff (14) so ausgebildet und angeordnet ist, dass eine elektrische Isolation zwischen den Außenelektroden (6) (7) einerseits und den piezoelektrischen Aktorelementen (2, 2', 2'') sowie den Innenelektroden (3, 3', 3'') andererseits gewährleistet ist.

7. Piezoelektrischer Aktor (1) nach Anspruch 5 oder 6
**dadurch gekennzeichnet, dass**
die Schichtdicke des Klebstoffes (14) zwischen den Außenelektroden (6) (7) einerseits und den piezoelektrischen Aktorelementen (2, 2', 2'') sowie den Innenelektroden (3, 3', 3'') andererseits, durch den Zusatz von Partikeln mit vorgegebener Korngröße bestimmt ist.

8. piezoelektrischer Aktor (1) nach einem der Ansprüche 5 bis 7
**dadurch gekennzeichnet, dass**
der Klebstoff (14) kraftstoffresistent ist.

9. Piezoelektrischer Aktor (1) nach einem der vorigen Ansprüche
**dadurch gekennzeichnet, dass**
der piezoelektrische Aktor (1) vollständig mit Klebstoff (14) ummantelt ist.

10. Piezoelektrischer Aktor (1) nach einem der vorigen Ansprüche
**dadurch gekennzeichnet, dass**
die Außenelektroden (6) (7) aus einer Bronzelegierung durch Ätzen hergestellt sind.

## Claims

1. Piezoelectric actuator (1) comprising
- a stack of a plurality of individual piezoelectric actuator elements (2, 2', 2'') which are disposed between inner electrodes (3, 3', 3'') and which contract or expand in a main oscillation direction (10) as a function of an applied electric voltage,
- a first metallisation strip (4) and a second metallisation strip (5), the inner electrodes (3, 3', 3") being respectively connected in an alternating manner to the first or second metallisation strip (4) (5),
- a first outer electrode (6) and a second outer electrode (7) which are respectively fixed to the first or the second metallisation strip (4) (5) in order to electrically contact the piezoelectric actuator (1) and
- a first connection element (8) and a second connection element (9) for externally contacting the piezoelectric actuator (1) which are respectively connected to the first or the second outer electrode (6) (7),
with
- the outer electrodes (6) (7) comprising at least one region which is embodied in such a way that it compensates length variations of the piezoelectric actuator (1) in the main oscillation direction (10) as a result of its design and arrangement by means of elastic deformation exclusively inside a plane in each case which is parallel to the main oscillation direction (10) and
- the outer electrodes (6) (7) comprising a comb-shaped profile with contact teeth (11) (11') to contact the metallisation strips (4) (5),
**characterised in that**
the outer electrodes (6) (7) comprise a wave-form conductor plate (16) (16'), from which the contact teeth (11) lead away.

2. Piezoelectric actuator (1) according to claim 1,
**characterised in that**
the wave-form conductor plate tapers along its principal axis (18) (18').

3. Piezoelectric actuator (1) according to claim 1 or 2,
**characterised in that**
the contact teeth (11) (11') run parallel to each other and are all the same length at a first end (12) (12') and the contact teeth (11) (11') at this end (12) (12') are soldered on the metallisation strips (4) (5) for electric contact.

4. Piezoelectric actuator (1) according to one of claims 1 to 3,
**characterised in that**
the outer electrodes (6) (7) are curved at an angle α < 90° in order to be fixed to the piezoelectric actuator (1), parallel to the first, straight end region (12) (12') of the contact teeth (11) (11').

5. Piezoelectric actuator (1) according to one of claims 1 to 4,
**characterised in that**
the outer electrodes (6) (7) on the piezoelectric actuator (1) are fixed mechanically by means of an adhesive (14) to the piezoelectric actuator (1) and the contact teeth (11) (11') for soldering to the metallisation strips (4) (5) are left out when the adhesive (14) is applied.

6. Piezoelectric actuator (1) according to claim 5,
**characterised in that**
the adhesive (14) is designed and arranged in such a way that electric insulation is ensured between the outer electrodes (6) (7) on the one hand and the piezoelectric actuator elements (2, 2', 2") and the inner electrodes (3, 3', 3'') on the other hand.

7. Piezoelectric actuator (1) according to claim 5 or 6,
**characterised in that**
the thickness of the layer of adhesive (14) between the outer electrodes (6) (7) on the one hand and the piezoelectric actuator elements (2, 2', 2") and the inner electrodes (3, 3', 3'') on the other hand is determined by the admixture of particles of a preset size.

8. Piezoelectric actuator (1) according to one of the claims 5 to 7,
**characterised in that**
the adhesive (14) is fuel-resistant.

9. Piezoelectric actuator (1) according to one of the preceding claims,
**characterised in that**
the piezoelectric actuator (1) is completely covered with adhesive (14).

10. Piezoelectric actuator (1) according to one of the preceding claims,
**characterised in that**
the outer electrodes (6) (7) are made from a bronze alloy using etching.

## Revendications

1. Actionneur piézoélectrique (1) comprenant
- une pile de plusieurs éléments d'actionneur piézoélectriques (2, 2', 2'') individuels disposés entre des électrodes internes (3, 3', 3''), qui se contractent ou s'étendent en fonction d'une tension électrique appliquée, dans une direction d'oscillation principale (10),
- une première bande de métallisation (4) et une deuxième bande de métallisation (5), les électrodes internes (3, 3', 3'') étant respectivement reliées alternativement avec la première ou la deuxième bande de métallisation (4) (5),
- une première électrode externe (6) et une deuxième électrode externe (7) qui, pour la mise en contact électrique de l'actionneur piézoélectrique (1), sont fixées à la première ou à la deuxième bande de métallisation (4) (5) et
- un premier élément de connexion (8) ainsi qu'un deuxième élément de connexion (9) pour la mise en contact externe de l'actionneur piézoélectrique (1), qui sont respectivement reliés à la première ou à la deuxième électrode externe (6) (7),
- les électrodes externes (6) (7) comprenant au moins une zone configurée de telle sorte qu'elle compense les variations de longueur de l'actionneur piézoélectrique (1) dans la direction d'oscillation principale (10) grâce à sa forme et à sa disposition, par déformation élastique, exclusivement à l'intérieur d'un plan respectif qui s'étend parallèlement à la direction d'oscillation principale (10) et
- les électrodes externes (6) (7) présentent un profil en forme de peigne avec des dents de contact (11) (11') pour la mise en contact des bandes de métallisation (4) (5),
**caractérisé en ce que**
les électrodes externes (6) (7) présentent une platine conductrice en forme de méandre (16) (16') à partir de laquelle partent les dents de contact (11).

2. Actionneur piézoélectrique (1) selon la revendication 1,
**caractérisé en ce que** la plaque conductrice en forme de méandre se rétrécit le long de son axe médian (18) (18').

3. Actionneur piézoélectrique (1) selon la revendication 1 ou 2,
**caractérisé en ce que** les dents de contact (11) (11') s'étendent parallèlement les unes aux autres et présentent toutes, au niveau d'une première extrémité (12) (12'), la même longueur, et les dents de contact (11) (11'), au niveau de cette extrémité (12) (12'), sont soudées aux bandes de métallisation (4) (5) pour la mise en contact électrique.

4. Actionneur piézoélectrique (1) selon l'une des revendications 1 à 3,
**caractérisé en ce que** les électrodes externes (6) (7), pour la fixation à l'actionneur piézoélectrique (1), sont courbées parallèlement à la première zone d'extrémité droite (12) (12') des dents de contact (11) (11'), selon un angle α inférieur à 90°.

5. Actionneur piézoélectrique (1) selon l'une des revendications 1 à 4,
**caractérisé en ce que** les électrodes externes (6) (7) sont fixées sur l'actionneur piézoélectrique (1) mécaniquement au moyen d'un adhésif (14) et les dents de contact (11) (11') ne sont pas recouvertes lors de l'application de l'adhésif (14) pour permettre le brasage aux bandes de métallisation (4) (5).

6. Actionneur piézoélectrique (1) selon la revendication 5,
**caractérisé en ce que** l'adhésif (14) est configuré et disposé de telle sore qu'une isolation électrique est garantie entre les électrodes externes (6) (7) d'une part et les éléments d'actionneur piézoélectriques (2, 2', 2'') ainsi que les électrodes internes (3, 3', 3") d'autre part.

7. Actionneur piézoélectrique (1) selon la revendication 5 ou 6,
**caractérisé en ce que** l'épaisseur de couche de l'adhésif (14) entre les électrodes externes (6) (7) d'une part et les éléments d'actionneur piézoélectriques (2, 2', 2'') ainsi que les électrodes internes (3, 3', 3'') d'autre part est déterminée par l'ajout de particules ayant une taille de grain prédéterminée.

8. Actionneur piézoélectrique (1) selon l'une des revendications 5 à 7,
**caractérisé en ce que** l'adhésif est résistant au carburant.

9. Actionneur piézoélectrique (1) selon l'une des revendications précédentes,
**caractérisé en ce que** l'actionneur piézoélectrique (1) est complètement enveloppé d'adhésif (14).

10. Actionneur piézoélectrique (1) selon l'une des revendications précédentes,
**caractérisé en ce que** les électrodes externes (6) (7) sont fabriquées à partir d'un alliage de bronze, par gravure.
